# EUROPEAN PATENT APPLICATION

(11) **EP 4 790 904 A1**
(43) Date of publication of application: **12.08.2026**
(21) Application number: 26157294.5
(22) Date of filing: 09.02.2026
(51) Int. Cl.: H03M 7/30

(54) **GRAPHICAL APPLICATION FOR NOISELESS WAVEFORM RECOVERY AND COMPARISON OF COMPRESSED SENSING SCHEMES IN HIGHLY COMPRESSED SIGNALS**

(30) Priority: 10.02.2025 US 202563756676 P
(71) Applicant: KBR Wyle Services, LLC, Houston, TX 77002 (US)
(72) Inventor: LAAG, Edward A., Leesburg, VA, 20175 (US); RUBENSTEIN, Rafael Ilan, Prussia, PA, 19406 (US)
(74) Representative: Weickmann & Weickmann PartmbB

(57) **Abstract**

A method for compressed signal and image reconstruction with multiple compressed sensing schemes is disclosed. The method includes obtaining data of a scene to be reconstructed and receiving sampling parameters and one or more compressed sensing schemes to be applied for sampling and reconstruction of the obtained data. The method includes initially reconstructing the data using one or more compressed sensing schemes, in accordance with received sampling parameters and then comparing the reconstructed data results for each of the compressed sensing schemes using a series of built in visual feedback windows, numerical metrics, model-based metrics and other analysis tools. The method allows for inputting either compressed or classically sampled data, enabling two possible operational modes. In either case, this method allows the user to identify the best scheme(s) to meet their specific need. Corresponding electronic device and non-transitory computer-readable medium for data reconstructions with multiple compressed sensing schemes are disclosed.

## Description

### FIELD OF THE INVENTION

The present disclosure relates to signal processing of compressed data streams. More particularly relates to an interactive graphical application for engaging and effectively assessing compressed sensing schemes, an electronic device running the application and a non-transitory computer-readable medium for storing parallel data reconstructions with multiple compressed sensing schemes.

### BACKGROUND OF THE INVENTION

In the field of signals analysis, factors such as inclement weather, signal disruption, collection geometry, insufficient memory, premature equipment failure and other sensor limitations may lead to incomplete sampling. In other cases, the data collection is intentionally made sparse.

In the state of the art, compressed sensing, also referred to as compressive sensing or sparse sampling, is a signal processing technique capable of efficiently reconstructing and estimating a population of original signals based on very few initial sampling points supplied as a subset. It exploits the data sparsity to algorithmically recover and predict original signals depending on these sampling values, and in some cases may restore the signal to an effectively noiseless result. In other words, compressed sensing is defined as a mathematical means to find solutions to an underdetermined linear system.

Due to its powerful potential to recover signals beyond traditional limits and thereby reduce file sizes, it is known for having utility in industries such as information & communication, computation, electronics and electrical engineering, etc., Compressive sensing techniques have been widely applied in technical fields, such as image processing, signal processing and computation, to enable a variety of key functions such as image compression, audio compression, up-sampling, degraded signal recovery, sparse encoding, antenna design, radar design, processing for remote sensing, computational photography, etc.

Therefore, at core compressed sensing is a collection of methods for finding sparse solutions in underdetermined linear systems. These can be described in simple terms as problems for which there are more unknown than known quantities. The equation generally used in the application is expressed as shown in the following formula (1). $Y = φ \times X$ in which Y is an observed value, i.e., the detected (spare sampled) signals or images. φ is a sensing matrix, and X is an original signal matrix. In the case of full rank, the matrix X can be solved for directly using linear algebra.

However, in the more common case of the underdetermined matrix, observed value Y cannot be solved directly. Therefore, there are related algorithmic techniques using compressed sensing to find solutions in the underdetermined matrix. Although a solution can be found by using compressed sensing, different methods have different recovery characteristics, and therefore it is difficult to confirm whether the chosen restoration method is the best choice for a given input sample. This is particularly challenging when an original truth sample is not available.

Though compressed sensing technology has existed and been developed for over two decades, there is not a singular method to quickly and correctly determine that the signal has been optimally restored because the meaning of this largely depends on end user requirements.

### SUMMARY

The proposed method described herein offers an intuitive graphical user interface which may be used for defining sampling parameters for data recovery and efficient data reconstructions with one or more compressed sensing schemes applied as described herein. The proposed method in examples, substantially solves one or more of the problems due to limitations and disadvantages of the related art or at least provides the public with a useful, functional alternative.

In examples, the method and the electronic device described herein may provide improved data reconstruction by comparing the reconstructed data to an original data for each of the compressed sensing schemes.

In examples, the proposed method, an applications interface and the electronic device described herein provide improved reconstruction performance by allowing users to visually compare and contrast the recovered data for a multitude of compressed sensing schemes/algorithms graphically (with an ability to add more options), and by assessing results based on performance metrics contained within the interface.

In examples, the method and the electronic device as described may overcome one or more of the problems described above.

In examples, one or more compressed sensing schemes may be used for data reconstruction and the recovered data for each of the compressed sensing schemes may be verified alongside the original data.

In examples, the reconstructed data may be exported or saved for further analysis. In some examples, the graphical user interface described herein may receive sampling parameters to be applied on the data itself and the graphical interface is designed to aid the user in assessing the quality or effectiveness of the reconstruction method with multiple compressed sensing techniques against a variety of pre-determined user requirements.

The prior art generally fails to offer a method to quickly and correctly determine that the data and/or a signal has been restored to user satisfaction.

In examples, there is provided, a method for data reconstruction with various compressed sensing schemes. The method may include obtaining data of a scene to be reconstructed and receiving sampling parameters and one or more compressed sensing choices to be applied for sampling and reconstruction of the obtained data. The method may include reconstructing the data using one or more compressed sensing schemes, in accordance with received sampling parameters. Further, the method may include comparing the reconstructed data to an original data for each of the compressed sensing schemes or algorithms applied.

In examples, the method may include verifying the reconstructed data by comparing the reconstructed data for each of the compressed sensing scheme with an original data. The method may include importing the data at a classically sampled rate higher than an effective Nyquist rate and applying a decimation step, which is described below. Alternatively, the method may include importing data that is previously compressed, in which case the decimation step is not applicable, but the reconstruction capability is being leveraged.

In some examples, the method may include indicating (plotting or displaying) the reconstructed data for each of the compressed sensing schemes. Further, the method may include storing the reconstructed data for each of the compressed sensing schemes for additional analysis of the reconstructed data.

In examples, receiving sampling parameters and one or more selectable compressed sensing schemes to be applied for sampling and reconstruction of the obtained data may also include determining whether the obtained data is sampled in a classical uniform manner, or determining whether the obtained data is sampled in a sparse, non-uniform manner (typically less than the calculated Nyquist sampling frequency). The method may include receiving a new sampling rate parameter to be applied for sampling the obtained data, in response to the above. This may result in the data being down-sampled at a rate less than the calculated Nyquist sampling frequency. Further, the method may include receiving the one or more compressed sensing scheme choices to be used for reconstructing the obtained data.

In examples, receiving sampling parameters and one or more selectable compressed sensing schemes to be applied for sampling and reconstruction of the obtained data may include determining whether the obtained data is compressed at a rate lower than the sampling rate defined by Nyquist in a sparse, non-uniform manner and determining to sample the obtained data at a desired sampling rate greater than the Nyquist sampling frequency), in response to determining that the obtained data is sampled at a sample rate less than the sampling rate defined by Nyquist. The method may include receiving a new sampling rate to be applied for reconstructing the obtained data, to achieve a classically reconstructed result in response to determining that the obtained data is to be sampled at the sampling rate greater than the Nyquist sampling frequency. Further, the method may include receiving one or more compressed sensing schemes to be used for reconstructing the obtained data.

In examples, the sampling parameters and the one or more compressed sensing schemes are user selected via a graphical user interface.

In examples, the obtained data comprises one or more of: an image file, a signal, an audio file, a multimedia file and a compressed file representing any of the above.

In examples, the sampling parameters comprises one or more of: sampling rate, down sampling frequency, up sampling frequency, maximum samples, maximum iterations and error tolerance.

In examples, there is provided an electronic device. The electronic device may include a memory storing program instructions and one or more processors. The program instructions, when executed by the one or more processors, cause the one or more processors to obtain data of a scene to be reconstructed and receive sampling parameters and one or more compressed sensing schemes to be applied for sampling and reconstruction of obtained data. The program instructions, when executed by the one or more processors, cause the one or more processors to reconstruct the data using one or more compressed sensing schemes, in accordance with received sampling parameters and may calculate quality metrics, or in other ways allow for comparing or assessing the reconstructed data to an original data for each of the compressed sensing schemes.

In examples, there is provided a non-transitory computer-readable medium storing program instructions that, when executed by one or more processors, cause the one or more processors to obtain data of a scene to be reconstructed and receive sampling parameters and one or more compressed sensing schemes to be applied for sampling and reconstruction of the obtained data. Further, the non-transitory computer-readable medium storing program instructions that, when executed by one or more processors, cause the one or more processors to reconstruct the data using one or more compressed sensing schemes, in accordance with received sampling parameters and compare the reconstructed data to an original data for each of the compressed sensing schemes.

In examples, the proposed method may be used for accurate and in some cases noiseless data reconstruction using one or more compressed sensing schemes. Further, the proposed method can be applied to reconstruct the data if the data is sampled at or above a classical Nyquist sampling frequency or if the data is non-uniformly sampled or under-sampled. Accurate data reconstruction can be achieved using one or more compressed sensing schemes and the reconstructed data for each of the compressed sensing schemes may be compared to precisely determine the optimal compressed sensing scheme for a given use case.

In some examples, the reconstructed data may be verified by comparing the reconstructed data for each of the compressed sensing schemes with an original data, thereby determining the accurate data reconstruction through visual cues. Otherwise, the quality may be assessed with the aid of other metrics built into the method.

### BRIEF DESCRIPTION OF THE DRAWINGS

So that the recited features of the present invention can be understood in detail, a more detailed description of the invention may be had by reference to embodiments, some of which are illustrated in the appended drawings. It is to be noted, however, that the appended drawings illustrate only typical embodiments of this invention and are therefore not to be considered limiting of its scope, for the invention may admit to other equally effective embodiments.
FIG. 1 is a block diagram illustrating an example environment for carrying out the method, according to an embodiment as described herein.
FIG. 2 is a flow diagram illustrating a method for reconstructing data with multiple compressed sensing schemes, according to an embodiment as described herein;
FIG. 3 is a flow diagram illustrating a method for receiving sampling parameters and one or more compressed sensing schemes, according to an embodiment as described herein;
FIG. 4 is an example graphical user interface for receiving the sampling parameters and the one or more compressed sensing schemes to be applied for data reconstruction, according to an embodiment as described herein;
FIGS. 5A-5D are example graphs illustrating data reconstructions with multiple compressed sensing schemes, according to an embodiment as described herein;
FIG. 6 is a block diagram of an electronic device having various functional modules for executing the method, according to an embodiment as described herein; and
FIG. 7 is an example computing environment, according to an embodiment as described herein.

### DETAILED DESCRIPTION

Aspects of the present disclosure will be described more fully hereafter with reference to the accompanying drawings. The apparatus and methods disclosed herein can, however, be realized in many different forms and should not be construed as being limited to the aspects set forth. Like numbers in the drawings refer to like elements throughout.

Embodiments of the present disclosure will be described and exemplified more fully hereafter with reference to the accompanying drawings. The solutions disclosed herein can, however, be realized in many different forms and should not be construed as being limited to the embodiments set forth herein.

It will be appreciated that when the present disclosure is described in terms of a method, it may also be embodied in one or more processors and one or more memory storage units coupled to the one or more processors, wherein the one or more memory units store one or more programs that perform the steps, services and functions disclosed herein when executed by the one or more processors.

Generally, the word "module," "unit," or "block," as used herein, refers to logic embodied in hardware or firmware, or to a collection of software instructions. A module, a unit, or a block described herein may be implemented as software and/or hardware and may be stored in any type of non-transitory computer-readable medium or other storage device. In some embodiments, a software module/unit/block may be compiled and linked into an executable program.

Software modules/units/blocks configured for execution on electronic devices may be provided on a computer-readable medium, such as a compact disc, a digital video disc, a flash drive, a magnetic disc, or any other tangible medium, or as a digital download (and can be originally stored in a compressed or installable format that needs installation, decompression, or decryption prior to execution). Such software code may be stored, partially or fully, on a storage device of the executing computing device, for execution by the computing device.

The present disclosure relates to a method, a graphical software interface, an electronic device and a non-transitory computer readable medium for comparison of data reconstructions using multiple compressed sensing schemes. The method may include obtaining data of a scene to be reconstructed and receiving sampling parameters and one or more compressed sensing schemes to be applied for sampling and reconstruction of the obtained data. The method may include reconstructing the data via one or more compressed sensing schemes, in accordance with received sampling parameters. Further, the method may include comparing the reconstructed data to an original data for each of the compressed sensing schemes.

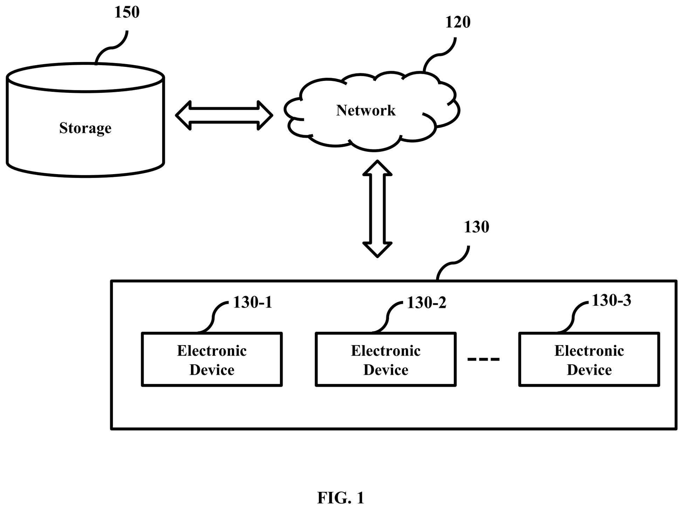

FIG. 1 is a block diagram illustrating an example environment 100, according to some embodiments of the present disclosure. As shown in the FIG. 1, the example environment 100 may include a network 120, one or more electronic devices 130, and a storage 150. All components depicted in environment 100 may be interconnected via the network 120.

In examples, the network 120 may include any suitable network that can facilitate exchange of information and/or data within the environment 100. In examples, the network 120 may be and/or include a public network (e.g., the Internet), a private network (e.g., a local area network (LAN), a wide area network (WAN)), etc.), a wired network (e.g., an Ethernet network), a wireless network (e.g., an 802.11 network, a Wi-Fi network, etc.), a cellular network (e.g., a Long Term Evolution (LTE) network), a virtual private network ("VPN"), a satellite network, a telephone network, routers, hubs, switches, server computers, and/or any combination thereof.

In some examples, the electronic devices 130-1, 130-2, and 130-3 which are collectively referred as 130 may include a mobile device, a tablet computer, a laptop computer, a single board computer (SBC), or the like, or any combination thereof. In some examples, the electronic device 130-1 may include a smart home device, a wearable device, a mobile device, a virtual reality device, an augmented reality device, or the like, or any combination thereof.

The storage 150 may store data, instructions, and/or any other information. In examples, the information and/or data stored in the storage 150 may be accessed by the electronic devices 130 via the network 120. In examples, the storage 150 may be connected to the network 120 to communicate with other components in the environment 100 (e.g., the terminal 130, etc.). One or more components in the environment 100 may access the data or instructions stored in the storage 150 via the network 120.

The electronic device 130 may include one or more processing units or processors which may execute the method described herein for reconstructing the data based on an image data acquired, for example, during a medical imaging procedure. The method of reconstruction may include any combination of compressed sensing schemes, related techniques, the model based tool as part of this disclosure, assessments described herein and other processing.

Compressed sensing may refer to a signal acquisition and processing technique for efficiently acquiring and reconstructing a signal. In compressed sensing, reconstruction of a signal (sometimes called recovery) may be performed by collecting a limited number of signal samples according to a defined set of sampling functions. The total number of signal samples may be smaller than the number required by Nyquist-Shannon sampling theory (classical sampling) but the signal samples may still contain sufficient information for recovering a noiseless original signal.

Thus, various compressed sensing schemes and/or techniques are used for data reconstruction. The method for optimizing data reconstruction quality or recovery using multiple compressed sensing schemes is explained in conjunction with figures in the later parts of the description.

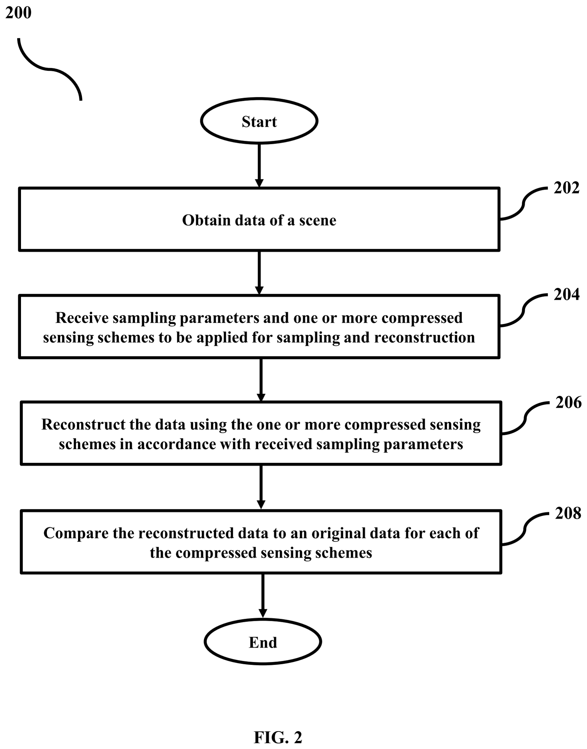

FIG. 2 is a flow diagram sequence illustrating a method 200 for reconstructing data with multiple compressed sensing schemes, according to an embodiment as described herein. The method 200 may include various steps (i.e., steps 202 to 208) that are performed by the electronic device 130. The electronic device 130 may include and/or implement one or more modules for executing the method 200 for reconstructing data using multiple compressed sensing schemes. As depicted in the flow diagram, at step 202, the method 200 may include obtaining data of a scene to be reconstructed. In examples, the obtained data may include an image file, a signal, an audio file, a radar collection, a multimedia file, and a compressed version of the above. In some examples, the data may be non-compressed data or a compressed data that may be used to enhance feature content within the scene, by recovering more information and detail.

At step 204, the method 200 may include receiving sampling parameters and one or more compressed sensing schemes to be applied for sampling and reconstruction of the obtained data. In examples, the choice of sampling parameters and one or more compressed sensing schemes are received through a graphical user interface (GUI) (displayed on the electronic device 130) which is designed for receiving the sampling parameters and the one or more compressed sensing schemes.

In examples, the sampling parameters may include a desired sampling rate (in some cases represents an up sampling), a down sampling frequency (if desired), maximum samples, error tolerance, and a maximum iterations value. In examples, the compressed sensing schemes (techniques) may include but not limited to Bayesian Compressed Sensing (BCS), L1-minimization, Sparse Least Squares (SPG-L1), Iterative Shrinkage Thresholding Algorithm (ISTA), Fast Iterative Shrinkage Thresholding Algorithm (FISTA), Approximate Message Passing (AMP), Orthogonal Matching Pursuit (OMP), Compressive Sampling Matching Pursuit (CoSaMP) Generalized Approximate Message Passing with Sparse Bayesian Learning (GAMP-SBL), Relevance Vector Machine with Expectation-Maximization (RVM-EM) or the like. Other unnamed techniques and schemes may be added or subtracted from this list. No claims are made that these particular schemes are necessary for the method to be performed, are the optimal schemes, or are necessary to the invention disclosure itself. These are representative only. The list of algorithms and how each operate are separated from the invention claim and the method we are describing in this disclosure.

It should be noted that the proposed method 200 may be applicable to additional compressed sensing schemes other than the compressed sensing schemes mentioned above. With the introduction to compressed sensing above, the implementation is principally composed of two important parts, sensing and reconstruction. In the sensing part, a sensing matrix that satisfies certain conditions is used to obtain a sparse signal. In the reconstruction step, a measurement vector and compressed sensing schemes are used to recover the original signal. Therefore, the one or more compressed sensing schemes may be utilized for data reconstruction and the underlying process of the data reconstruction is generally known in the art and thus the usage of compressed sensing schemes for data reconstruction is thus omitted here.

In examples, the choice of sampling parameters and the one or more compressed sensing schemes may be received from the user via a Graphical User Interface (GUI). The GUI may include text boxes, buttons, labels, text etc., through which the user may input the sampling parameters and the one or more compressed sensing schemes for reconstructing the obtained data. The user may input the sampling parameters such as the sampling rate, the down sampling frequency, the up-sampling frequency, maximum samples, maximum number of iterations, and the error tolerance through respective text boxes provided to the user on the GUI panels. Further, the one or more compressed sensing schemes (as mentioned above) to be applied for data reconstructions may be selected by the user, for example through a drop-down menu provided to the user on the GUI. Thus, the sampling parameters and the one or more compressed sensing schemes to be applied for sampling and reconstruction of the obtained data are received through the GUI provided to the user on the electronic device 100.

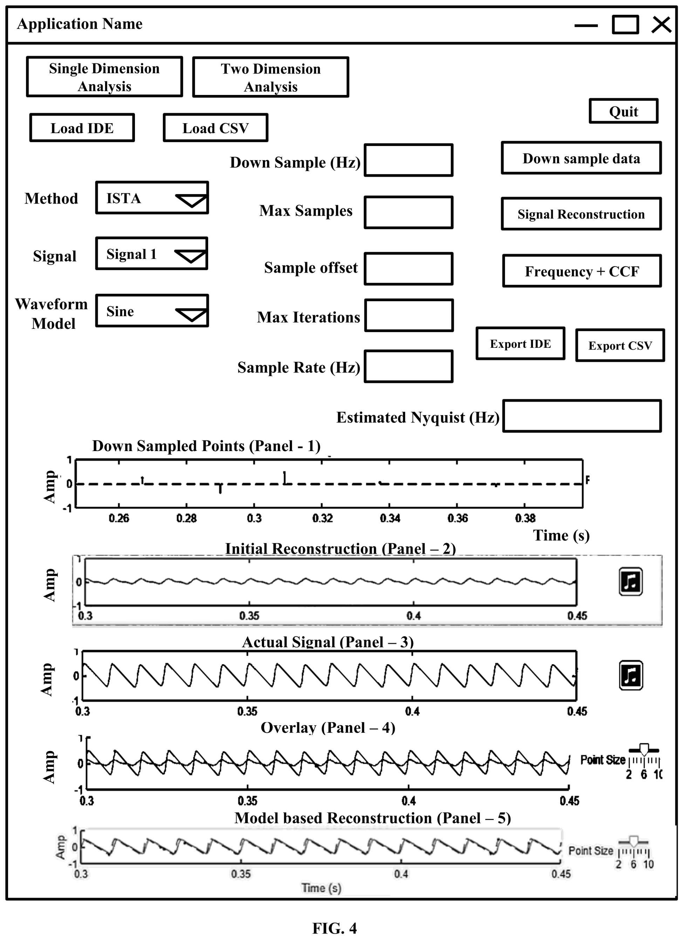

An example GUI provided to the user for receiving the sampling parameters and the one or more compressed sensing schemes for sampling and data reconstruction is shown in the FIG. 4.

At step 206, the method 200 may include reconstructing the data using the one or more compressed sensing schemes, in accordance with received sampling parameters. The data may be reconstructed by sampling the data with the received sampling parameters and by applying the one or more compressed sensing schemes.

In examples, the obtained data may be down-sampled according to a new sampling rate (selected by the user) if the obtained data is assessed to be sampled at a sampling frequency which is equal to or greater than the Nyquist sampling frequency. The process is sometimes termed decimation, because the input may be treated as a truth signal, which has been classically sampled. In other examples, the obtained data may need to be up-sampled according to a new sampling rate (set by the user) if the obtained data is determined to be sampled at a sampling frequency which is less than the Nyquist sampling frequency, or is otherwise sampled in a non-uniform or non-classical manner. The process is sometimes called decompression. Thus, the obtained data may either be down-sampled (decimated) or up-sampled (decompressed) in accordance with the new sampling rate selected by the user.

After sampling of the data, the one or more compressed sensing schemes are applied for reconstruction of the data. In examples, the user may select any of the aforementioned compressed sensing schemes for reconstructing the data, or ones as yet to be included in future versions of our application.

At step 208, the method 200 may include displaying and visually comparing the reconstructed data to an original data for each of the compressed sensing schemes. After data reconstruction, the recovered data for each compressed sensing scheme may be stored for later analysis. Storing of the reconstructed data can be useful for comparing the resulting data for each of the compressed sensing schemes. Thus, the user may compare the reconstructed data for each of the compressed sensing schemes visually to evaluate the quality and/or effectiveness of the specific scheme in reconstructing the data. The GUI described herein provides built-in display windows with plots and graphs for this purpose. The user may also view various performance metrics as a method of evaluation which will be described subsequently.

In examples, method 200 may include verifying the reconstructed data by comparing the recovered data for each of the compressed sensing schemes with an original data. The original data (if available) may be obtained and the reconstructed data produced at step 206 for each of the compressed sensing schemes may be verified against the original data to determine whether the recovered data matches with the original data. One of the key advantages with method 200, is that the users may evaluate which of the compressed sensing schemes can be used for most accurately reconstructing the data based on verification of the reconstructed data with the original data.

Further, method 200 may include displaying and indicating the reconstructed data for each of the compressed sensing schemes as plots or images. In some examples, the reconstructed data for each of the compressed sensing schemes may be displayed on the GUI of the electronic device 130. In other examples, the reconstructed data may be evaluated as a sound icon (if the recovered signal is an audio signal) on the electronic device 130.

In examples, method 200 may include storing the reconstructed data for each of the compressed sensing schemes for outside analysis of the reconstructed data. The reconstructed data for each compressed sensing schemes can be stored for further analysis.

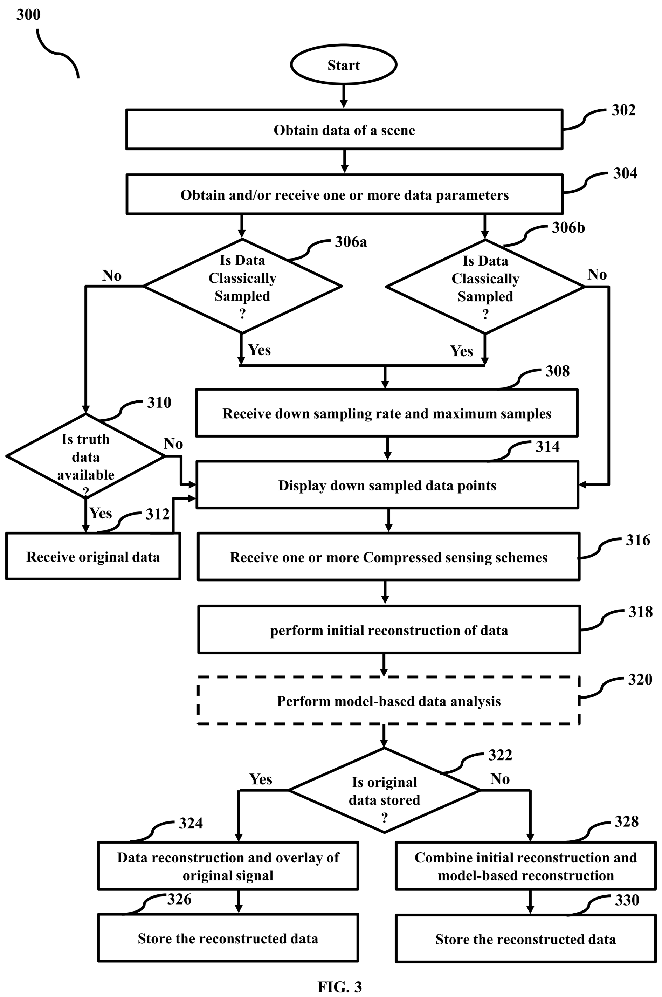

FIG. 3 is a flow diagram illustrating a method 300 for receiving input data, sampling parameters and one or more compressed sensing schemes for reconstructing the data, according to an embodiment as described herein. The electronic device 130 may be adapted for receiving the sampling parameters and choice of one or more compressed sensing schemes for reconstructing the data. The sampling parameters and one or more compressed sensing schemes may be received by the electronic device via the GUI.

As depicted in the flow diagram, at step 302, the method 300 may include obtaining data of a scene. In examples, the obtained data may include an image file, an audio file, a multimedia file, a communications signal, a radar signal or the like. In some examples, the data may be non-compressed data (classically sampled) or compressed versions of the above.

At step 304, the method 300 may include obtaining and/or receiving data parameters. In examples, the user may load the data for processing through an Integrated Development Environment (IDE) or the user may import a Comma-Separated Value (CSV) file or an image file (format TBD). After obtaining the data of the scene, various parameters of the data such as time series, sampling rate are obtained by the electronic device 130. For example, a sample signal tone and the sampling rate are obtained by the electronic device 130.

When the data is loaded through the IDE, at step 306a, the method 300 may include determining whether the obtained data is sampled in a classical, uniform manner in accordance with a constant sampling rate. This determines whether the input data is already compressed or is classically sampled. This determination serves as a proxy for determining if the data are effectively Nyquist sampled, as there is no perfect test to determine the latter state in the case where knowledge is incomplete. After obtaining the sampling rate and the time series data, the electronic device 130 may determine whether the obtained data is sampled in a classical, uniform manner. Optionally, the method may include a step where the effective Nyquist sampling frequency is estimated, which be used to enhance analysis and for metric performance purposes.

When the data is imported through a CSV file, at step 306b, the method 300 may include determining whether the received data is sampled in a classical uniform manner, as described for step 306a.

If at step 306a or at step 306b, when it is determined that the received data is sampled in a classical, uniform manner matching typical Nyquist theorem conditions, then at step 308, the method 300 may include receiving sampling parameters which may include a down sampling rate and maximum samples. In such a case, the data can be assumed to be already sampled at or above the effective Nyquist sampling frequency, and the user may select a down sampling rate and maximum samples for decimating or down-sampling the data at a new effective rate. In some examples, the down sampling rate and the maximum samples may be received from the user for decimating and/or resampling the data.

At step 314, the method 300 may include displaying down sampled data points. After down-sampling the data with the down sample data rate, the electronic device may display the down sampled data points, for example, in the GUI.

In case, at step 306a, if it is determined that the data is not classically sampled, at step 310, the method 300 may include determining whether a truth signal or an original signal of the data is available. If it is determined that the truth signal or the original signal is available, then the method 300 may include obtaining the truth signal or the original signal. The electronic device 130 may obtain the truth signal or the original signal from input.

At step 312, after receiving the truth signal, at step 314, the method 300 may include displaying the down-sampled data points. Thus, in some examples, the electronic device 130 may be adapted to display the down-sampled data points according to the down-sampling rate (selected by the user) when the data is classically sampled or the electronic device 130 may be adapted to display original compressed data points when the provided data is not classically sampled, also known as under-sampled (i.e., typically less than Nyquist sampling frequency for the signal).

In any case, at step 312, if it is determined that the truth signal or the original signal is not available, then at step 314, the method 300 may include displaying the down-sampled data points alone. Thus, the electronic device may be adapted to display the down sampled data points, for example, in the GUI.

Further, at step 316, the method 300 may include receiving a selection of one or more compressed sensing schemes. The one or more compressed sensing schemes to be applied for data reconstruction may be received from the user input via the GUI. At step 318, the method 300 may include performing initial reconstruction of the data using one or more compressed sensing schemes.

At step 320, the method 300 may include performing model-based analysis for the reconstructed data. In some examples, model-based signal analysis may be used for obtaining a final version of the reconstructed data. An existing model may be used to match the recovered data for obtaining the "noiseless" reconstructed signal. Thus, model-based signal processing (MBSP) may be used to determine the reconstructed data which may enhance the initial reconstruction, or it may aid in determining which scheme is performing the best. In examples, the model may be applied to the data and the signals are matched.

At step 322, the method 300 may include determining whether the original "truth" signal is stored on the electronic device 130. If it is determined that the original signal is stored, at step 324, the method 300 may include overlaying the original "truth" signal on the reconstructed signal for visual analysis. The truth data (if available) may be obtained and the reconstructed data obtained may be verified in comparison to the truth data to determine whether the reconstructed data matches. One of the key advantages with the method 200 is that the analysts may verify the accuracy of the reconstructed data with the original data when the truth signal is available. This visual feedback would be in addition to other performance metrics which are built in.

At step 326, the method 300 may include storing the reconstructed data. If at step 322, when it is determined that the truth signal is unavailable, then at step 328, the method 300 may include storing the original compressed data points (inputs) and initially reconstructed data for each of the compressed sensing schemes for subsequent analysis of the reconstructed data. The reconstructed data for each compressed sensing schemes may be stored for later analysis.

FIG. 4 is an example graphical user interface for receiving sampling parameters and one or more compressed sensing schemes to be applied for sampling and reconstruction of data, according to an embodiment as described herein. As depicted in the FIG. 4, the graphical user interface (GUI) includes multiple text boxes and buttons through which the user may input sampling parameters and one or more compressed sensing schemes to be applied for reconstruction of the data.

In examples, the GUI may be provided by a MATLAB application. The GUI is intuitive to the user for analysis of 1D signals and 2D signals (i.e. images) using single dimension analysis or two-dimensional analysis buttons respectively.

The user may load from an Integrated Development Environment (IDE) through a "load IDE" button as shown in the FIG. 4. The IDE is a software that combines commonly used developer tools into a compact GUI application. It is a combination of tools like a code editor, code compiler, and code debugger with an integrated electronic device. Thus, the GUI is integrated with features like software editing, building, testing, and packaging in a simple-to-use tool.

In examples, a "load CSV" button on the GUI may enable the user to import a Comma-Separated Value (CSV) file which is one of the prevalent and accessible file formats for storing and exchanging tabular data. Reading from a CSV file is performed using a reader object. In examples, the CSV file may be opened as a text file with Python's built-in open() function, which returns a file object. In this example, the CSV file may by opened in READ mode, file object is converted to 'csv.reader' object. Thus, the user may load the data into the GUI by clicking the "load CSV" button. Multiple 1-D signals can be read at once using this import method.

In examples, the GUI may obtain the data from the CSV file. The data may be sampled in a classical, uniform manner in accordance with a constant sampling rate. For this data, the user may enter a down-sampling rate in Hz (i.e., through a text box down sample"), which is less than the effective Nyquist sampling rate. The data is then decimated internally to a new under-sampled rate (compressed). In this case, when it is determined that the data is sampled classically, the advantage is that a "truth" comparison can be made with an original signal. The user may use the "truth" signal to assess the applicability of a particular compressed sensing scheme or technique to a known problem.

Further, the user may input the sampling parameters such as maximum samples, error tolerance, maximum iteration etc., through the respective text boxes as shown in the FIG. 4.

After the sampling parameters are provided in the text boxes, one or more compressed sensing schemes may be selected by the user for initial data reconstruction, in accordance with the sampling parameters. In some examples, an estimated Nyquist sampling frequency may be indicated or provided to the user via an "estimated Nyquist sampling frequency" text box as shown in the FIG. 4. This estimation can be used as part of the analysis metrics but requires the initial reconstruction. An FFT rendering, using the initial reconstruction can also be viewed using this button.

In the above example, if the user selects a down-sampling rate in Hz and upon clicking a "down sample data" button, the data is decimated internally to a new under-sampled rate and the down sample data points are displayed as shown in Panel-1 of the GUI.

The user may select any of the compressed sensing schemes to be applied for data reconstruction and upon clicking the "signal reconstruction" button, the initial reconstruction of the data may be presented as shown in Panel-2 of the GUI.

After the initial reconstruction stage, the reconstructed signal may be compared with the original signal or actual signal. The actual signal which is pre-stored may be indicated (plotted) by the GUI as shown in Panel-3. The reconstructed signal may be compared with the original signal by overlaying the reconstructed signal on the original signal, in the same plot window, as shown in Panel-4.

In case, when the original signal or a "truth signal" is not available, a model-based signal reconstruction technique may be utilized for obtaining a noiseless representation of the original signal and the model-based reconstructed data may then be compared against the initial reconstructed signal for verifying whether the initial reconstructed signal matches with the model based reconstructed signal, as shown in Panel-5. The model-based reconstructed signal is part of the analysis metrics, to be employed when there is no truth signal or classically sampled original data). The model-based signal analysis tools are accessed via a drop-down menu on the GUI.

In another example, the user may load the data which is sampled at a rate less than the Nyquist sampling frequency (i.e., under-sampled, compressed data). That is, the data is already down-sampled (decimated) to a rate much lower than 2×f (where f represents highest natural frequency tone of a signal). In such case, although there will not be a "truth" signal or an "original signal" available, any kind of data which is already compressed, may be uncompressed and reconstructed to a desired new up-sampled rate. In this case, the user may input the sampling parameters such as maximum samples, error tolerance, maximum iteration etc., through the respective text boxes.

After the sampling parameters are provided in the text boxes, one or more compressed sensing schemes may be selected by the user for data reconstruction in accordance with the sampling parameters.

In the above example, if the user selects a new sampling rate in Hz, the data may be up-sampled internally to the new sampled rate and the sample data points are displayed as shown in Panel-2 of the GUI. This initial reconstruction will have the benefit of uniform sampling at the desired rate, even if the original data are sampled in a non-uniform manner. Further, a model-based signal reconstruction technique may be utilized for obtaining the "noiseless" reconstruction of the "original" signal and the reconstructed original signal may then be compared against the initial reconstructed signal for verifying whether the initial reconstructed signal matches with a representative model based reconstructed signal adequately, as shown in the Panel-5. This is part of the built in model based signal analysis metrics, and is accessed via drop-down menu on the GUI. At this point, additional metrics may also be employed to determine whether the results are sufficient, or a different scheme should be applied. An example would be the cross-correlation function.

Once reconstructed, the resulting data may be exported to the IDE (i.e., vector or array variable) for further analysis or saved in a CSV text file. The buttons "export IDE" and "export CSV" may be used to export the reconstructed data for further analysis.

In examples, the user may clear (which will clear the analysis windows), and then select any other compressed sensing scheme and reconstruct the input data using the selected compressed sensing scheme. The user may then compare the results of the reconstructed data of one compressed sensing scheme with the result of the reconstructed data of another compressed scheme. Thus, the GUI is designed to aid the user in actively assessing the quality or effectiveness of a reconstruction (also called "recovery") for multiple compressed sensing schemes against a variety of data problems. These comparisons of data reconstructions for multiple compressed sensing schemes are described in the examples below.

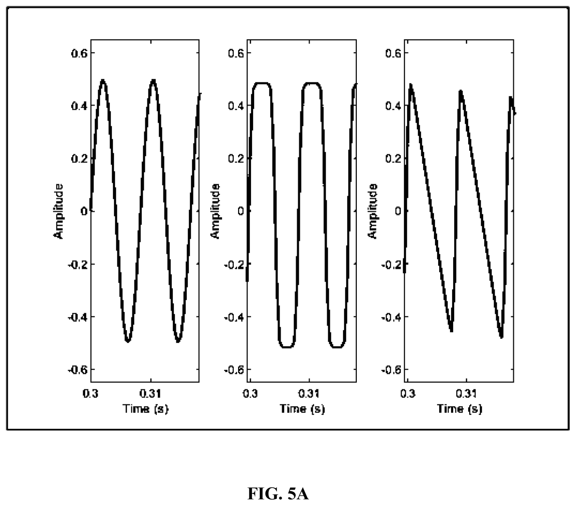

FIGS. 5A-5D are graphs illustrating example signal reconstructions with multiple compressed sensing schemes, according to an embodiment as described herein. In order to demonstrate the method for data reconstruction using one or more compressed sensing schemes via concrete examples, 1D signal analysis is performed. Initially, three elemental/essential test patterns are defined. These are representative waveforms and are extensible to more complicated signals, an infinite number in combination, or by changes in frequency. It should be noted that by no means it is suggested that the compressed sensing technique only applies in the case of such simple functions, rather the advantages of the proposed method 200 are demonstrated by using a form which may be easy to visualize.

The selected test inputs shown in Figure 5A are 1) a sinusoid wave, 2) a square wave and 3) a sawtooth wave. These input waveforms were generated at a natural frequency of 110 Hz. Each of these are convolved with a gaussian window, softening the edges in a way which is more akin to real sensing, but without the impacts of finite sampling windows. Finally, these signals are down sampled (decimated) to a 35-Hz (time averaged) baseline using a random sampling seed. It is to be noted that the sampling is non-uniform. The implied effective Nyquist rate of the three signals is at least 220 Hz. Thus, at a sampling rate of 35-Hz, the data are more than a factor of 6.3 under-sampled assuming a uniform base sampling. Some interpretations indicate sampling should be at minimum 2.3×f to classically sample a signal, thus the under-sampling factor can be considered higher by some definitions, when compared to the Shannon-Nyquist sampling theorem.

The selected time series duration is 5 seconds, thus at average 35 Hz sampling, only ~175 samples over this duration are needed, out of a possible 1100 at the 2×f rate, and 10,000 samples at a 2000 Hz rate. Hence, it is difficult to differentiate these signals when the sampling is so sparse. In any case, the number of samples the signals are compressed substantially due to the decimation.

To assess and compare performance of various compressed sensing schemes, the data are imported to the GUI and loaded as under-sampled data sets, equivalent to a vector of length ~175 points, sampled randomly at times t_{b}. This type of input is called a time-series. A uniform sampling rate of 2000 Hz is chosen as the reconstructed sample rate to achieve, and five example compressed sensing schemes are applied, allowing each technique enough iterations to reach a result.

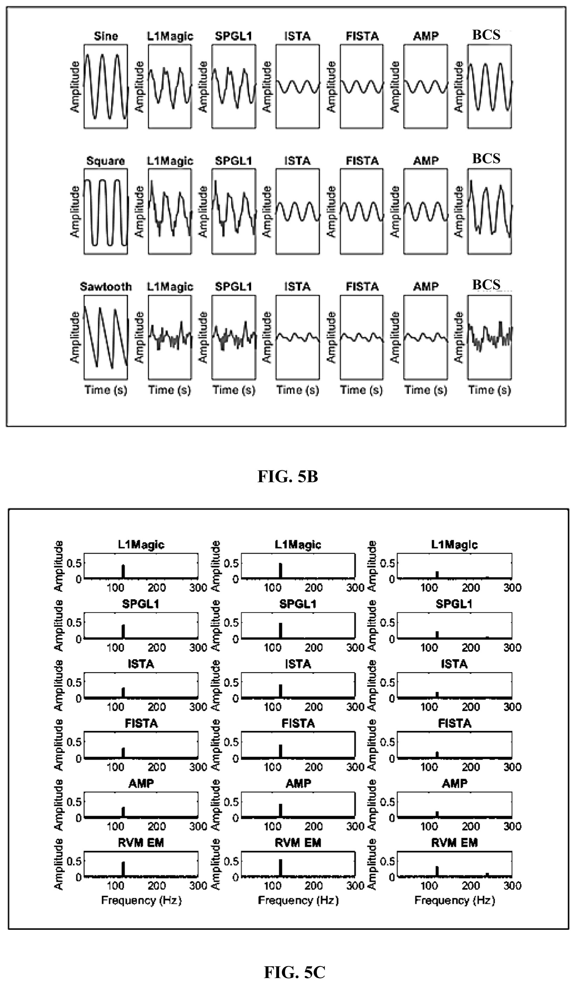

After completion of the initial reconstruction, FIG. 5B provides a visual snapshot comparison of five compressed sensing methods for the three test patterns shown in the FIG. 5A. The left-most column shows the truth ("Nyquist") uniformly sampled waveform, for reference. Each of the subsequent columns shows the initial reconstruction result for the methods as labeled, starting with L1-Magic. It should be noted the subtle behaviors of the individual compressed sensing schemes in the subplots are best viewed using the interactive analysis GUI, whereby one can picture a longer time sample (graphs may be scrolled left and right using a mouse). For example, it is observed that the L1-Magic scheme struggles to recreate the on/off dwells at full drop, but the ISTA and FISTA scheme are beginning to capture it, when compared to the smoothness of the sinusoid above. All the compressed sensing schemes were to some degree able to resolve the natural frequency. The BCS appears to improve on the Sawtooth data, as it moves to the right in time.

The performance of a compressed sensing scheme can be measured by how closely a compressed sensing scheme correctly recovers the natural frequency(s) of the original signal (one possible metric of many). Small differences in frequency or period, will not restore the signal accurately. Thus, a closer frequency estimation will lead to a better result as shown in FIG. 5C.

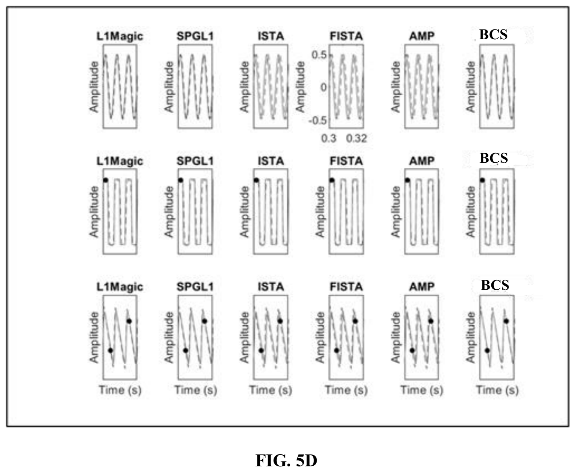

To produce the model-based reconstruction ("noiseless estimate") in 1-D, a dominant natural frequency is selected as shown in the plots from the initial reconstruction. For the three canonical waveforms, these are easily matched to the characteristics of the down-sampled data in combination with the above frequency, and the actual truth signal is recovered without loss as shown in FIG. 5D. Using the method 200 in our disclosure, compressed signals (nearly impossible to distinguish visually) to initial reconstructions (rough looking approximations of the canonical waveforms) to model-based analysis results (noiseless, visually well-aligned matches to the canonical waveforms).

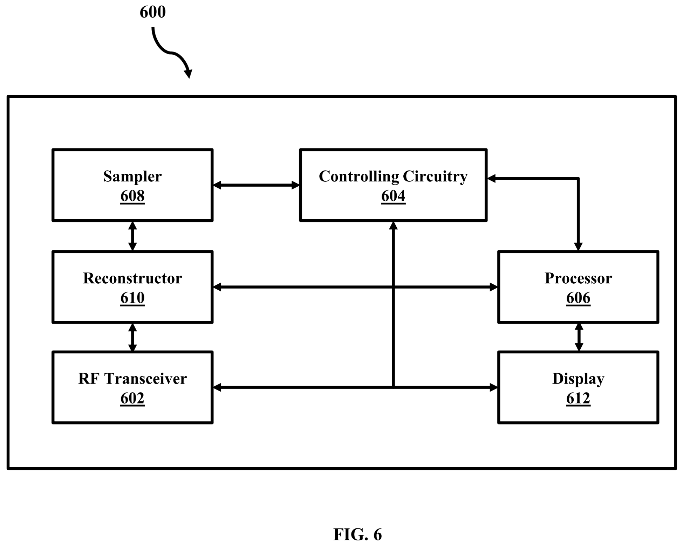

FIG. 6 is an example device 130 having functional modules. The apparatus 600 may be assembled in an device 130 (e.g. the electronic device 130 described in conjunction with FIG. 1). The electronic device 130 is capable of receiving the sample data and/or information. In examples, the electronic device 130 may be adapted to perform the method 200 for reconstruction of data using the one or more compressed sensing schemes.

In examples, the apparatus 600 as illustrated in FIG. 6 may comprise one or more modules. These modules may e.g. be a RF transceiver 602, a controlling circuitry 604, a processor 606, a sampler 608, a reconstructor 610 and a display 612. The controlling circuitry 604 may be adapted to control said modules.

It can be mentioned that the sampler 608 and the reconstructor 610 may be merged into the processor 606, which may be called a data processor, potentially also covering the controlling circuitry 604.

The sampler 608, the reconstructor 610, the display 612, the transceiver 602 and the controlling circuitry 604 may be operatively connected to each other.

The transceiver 602 may be adapted to receive and communicate information to and from the network 120. For example, the transceiver 602 may be adapted to receive the compressed signal data (e.g. a medical image) from the storage 150 via the network 120.

The processor 606 which may be considered as a data processing module, may in some embodiments be comprised in or form part of the controlling circuitry 604 and may be adapted to execute one or more instructions for data reconstruction using the one or more compressed sensing schemes.

In examples, the sampler 608 may be adapted to sample the obtained data using the sampling parameters received from the user. For example, the sampler 608 may be adapted to down-sample the obtained data according to the down sampling rate received from the user when it is determined that the obtained data is classically sampled. In another example, the sampler 608 may be adapted to up-sample the obtained data according to the sampling rate received from the user when it is determined that the obtained data is compressed.

In examples, the sampler 608 may be conceived as sampling a scene in real time (live) either classically or in a compressed manner.

After sampling the obtained data, the reconstructor 610 may be adapted to reconstruct the data using the selected one or more compressed sensing schemes received from the user. Reconstructor 610 may be capable of executing multiple compressed sensing schemes for recovering the data using the selected one or more compressed sensing schemes.

In examples, the display 612 may be adapted to provide an interactive GUI to the user. The GUI provided to the user may be include text boxes, drop down menus, buttons, tabs etc., through which the user may input the sampling parameters, select compressed sensing schemes etc., that are to be applied for reconstructing the obtained data. Thus, the analysis GUI provided to the user is intuitive and the GUI may enable the user to input various sampling parameters and make additional selections for data reconstruction, comparison and analysis of reconstructed data for each compressed sensing scheme to verify the reconstructed data.

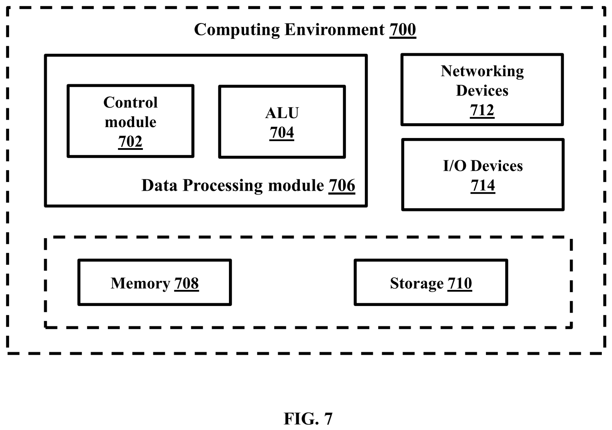

FIG. 7 is an example computing environment implementing the method and the electronic device for data reconstructions using multiple compressed sensing schemes as described in FIG. 2 and FIG. 3. As depicted in the FIG. 7, the computing environment 700 comprises at least one data processing module 706 that is equipped with a control module 702 and an Arithmetic Logic Unit (ALU) 704, a memory 708, a storage 710, a plurality of networking devices 712 and a plurality Input output, I/O devices 714. The data processing module 706 may be responsible for implementing the method described in FIG. 2 and FIG. 3. For example, the data processing module 706 may in some embodiments be equivalent to the processor of the electronic device 130 described above in conjunction with the FIG. 1. The processing unit 706 is capable of executing software instructions stored in memory 708. The processing unit 706 receives commands from the control unit 702 in order to perform its processing. Further, any logical and arithmetic operations involved in the execution of the instructions are computed with the help of the ALU 704.

The computer program is loadable into the data processing module 706, which may, for example, be comprised in an electronic apparatus (such as a UE or a network node). When loaded into the data processing module 706, the computer program may be stored in the memory 708 associated with or comprised in the data processing module 706.

According to some embodiments, the computer program may, when loaded into and run by the data processing module 706, cause execution of method steps according to, for example, any of the methods illustrated in FIGS. 2 and 3 or otherwise described herein.

The overall computing environment 700 may be composed of multiple homogeneous and/or heterogeneous cores, multiple CPUs of different kinds, special media and other accelerators. Further, the plurality of data processing modules 706 may be located on a single chip or over multiple chips.

The complete software algorithm consisting of instructions and codes required for the implementation are stored in either the memory 708 or the storage 710 or both. At the time of execution, the instructions may be fetched from the corresponding memory 708 and/or storage 710 and executed by the data processing module 706.

In case of any hardware implementations various networking devices 712 or external I/O devices 714 may be connected to the computing environment to support the implementation through the networking devices 712 and the I/O devices 714.

The embodiments disclosed herein can be implemented through at least one software program running on at least one hardware device and performing network management functions to control the elements. The elements shown in FIG. 7 include blocks which can be at least one of a hardware device, or a combination of hardware device and software module.

The words "comprising" and "comprises" as used throughout the claims, are to be interpreted to mean "including but not limited to" and "includes but not limited to", respectively.

Certain embodiments and features have been described using a set of numerical upper limits and a set of numerical lower limits. It should be appreciated that ranges from any lower limit to any upper limit are expected ordinary conditions unless otherwise indicated. Certain lower limits, upper limits and ranges appear in one or more claims below. All numerical values are "about" or "approximately" the indicated value, and experimental error and variations would be expected by a person having ordinary skill in the art.

Various terms have been defined above. To the extent a term used in a claim is not defined above, it should be given the broadest definition persons in the pertinent art have given that term as reflected in at least one printed publication or issued patent. Furthermore, all patents, test procedures, and other documents cited in this application are fully incorporated by reference to the extent such disclosure is not inconsistent with this application and for all jurisdictions in which such incorporation is permitted.

While the foregoing is directed to embodiments of the present invention, other and further embodiments of the invention may be devised without departing from the basic scope thereof, and the scope thereof is determined by the claims that follow.

## Claims

1. A method for data reconstruction using compressed sensing schemes, the method comprising:
obtaining compressed or non-compressed data of a scene to be reconstructed;
receiving via a graphical user interface, sampling parameters and one or more compressed sensing schemes to be applied for sampling and reconstruction of the obtained data;
reconstructing the data using the one or more compressed sensing schemes, in accordance with received sampling parameters; and
comparing the resulting reconstructed data to an original data for each of the compressed sensing schemes via the graphical user interface.

2. The method of claim 1, further comprising:
verifying the reconstructed data by comparing the initially reconstructed data for each of the compressed sensing schemes with an available original data.

3. The method of claim 1 or 2, further comprising:
displaying the initially reconstructed data for each of the compressed sensing schemes; and
storing the reconstructed data for each of the compressed sensing schemes for more detailed analysis of the reconstructed data.

4. The method of any one of claims 1-3, wherein receiving sampling parameters and selecting one or more compressed sensing schemes to be applied for sampling and initial reconstruction of the obtained data comprises:
determining whether the obtained data is sampled in a classical sense, according to traditional Nyquist sampling frequency;
determining to sample the obtained data at a sampling rate less than the Nyquist sampling frequency, in response to determining that the obtained data is sampled in classical uniform sense, in accordance with Nyquist sampling theory and at a corresponding rate greater than Nyquist; and
receiving a new user selected sampling rate to be applied for sampling the obtained data, in response to determining that the obtained data is to be sampled at the sampling rate less than the Nyquist sampling frequency; and
receiving one or more compressed sensing schemes to be used for reconstructing the obtained data.

5. The method of any one of claims 1-3, wherein receiving sampling parameters and one or more selectable compressed sensing schemes to be applied for sampling and reconstruction of the obtained data comprises:
determining whether the obtained data is compressed at a rate lower than the sampling rate defined by Nyquist;
determining to sample the obtained data at a desired sampling rate greater than the Nyquist sampling frequency, in response to determining that the obtained data is sampled at a sample rate less than the sampling rate defined by Nyquist;
receiving a new sampling rate to be applied for reconstructing the obtained data, in response to determining that the obtained data is to be sampled at the desired sampling rate greater than the Nyquist sampling frequency; and
receiving one or more compressed sensing schemes to be used for initially reconstructing the obtained data.

6. The method of any one of claims 1-5, wherein the sampling parameters and the one or more compressed sensing schemes are received via a graphical user interface.

7. The method of any one of claims 1-6, wherein the obtained data comprises one or more of: an image file, an audio file, a communication signal, an RF signal, radar data, a multimedia file or a compressed version of any data.

8. The method of any one of claims 1-7, wherein the sampling parameters comprises one or more of: a sampling rate, down sampling frequency, up sampling frequency, a maximum samples and an error tolerance, each user selectable.

9. An electronic device comprising:
a memory storing program instructions; and
one or more processors, wherein the program instructions, when executed by the one or more processors, cause the one or more processors to:
obtain data of a scene to be reconstructed;
receive sampling parameters and one or more compressed sensing schemes to be applied for sampling and reconstruction of the obtained data;
reconstruct the data using one or more compressed sensing schemes, in accordance with received sampling parameters; and
compare the reconstructed data to an original data for each of the compressed sensing scheme via the graphical user interface.

10. The electronic device of claim 9, wherein the program instructions, when executed by the one or more processors, cause the one or more processors to:
verify the reconstructed data by comparing the initially reconstructed data for each of the compressed sensing schemes with an available original data.

11. The electronic device of claim 9 or 10, wherein the program instructions, when executed by the one or more processors, cause the one or more processors to:
displaying the initially reconstructed data for each of the compressed sensing schemes; and
store the reconstructed data for each of the compressed sensing schemes for analysis of the reconstructed data.

12. The electronic device of any one of claims 9-11, wherein the program instructions, when executed by the one or more processors, cause the one or more processors to receive sampling parameters and one or more compressed sensing schemes to be applied for sampling and reconstruction of the obtained data by:
determining whether the obtained data is sampled in a classical sense, according to traditional Nyquist sampling frequency;
determining to sample the obtained data at a sampling rate less than the Nyquist sampling frequency, in response to determining that the obtained data is sampled in classical uniform sense, in accordance with Nyquist sampling theory and at a corresponding rate greater than Nyquist; and
receiving a new user selected sampling rate to be applied for sampling the obtained data, in response to determining that the obtained data is to be sampled at the sampling rate less than the Nyquist sampling frequency; and
receiving one or more compressed sensing schemes to be used for reconstructing the obtained data.

13. The electronic device of any one of claims 9-11, wherein the program instructions, when executed by the one or more processors, cause the one or more processors to receive sampling parameters and one or more compressed sensing schemes to be applied for sampling and reconstruction of the obtained data by:
determining whether the obtained data is compressed at a rate lower than the sampling rate defined by Nyquist;
determining to sample the obtained data at a desired sampling rate greater than the Nyquist sampling frequency, in response to determining that the obtained data is sampled at a sample rate less than the sampling rate defined by Nyquist;
receiving a new sampling rate to be applied for reconstructing the obtained data, in response to determining that the obtained data is to be sampled at the desired sampling rate greater than the Nyquist sampling frequency; and
receiving one or more compressed sensing schemes to be used for initially reconstructing the obtained data.

14. The electronic device of any one of claims 9-13, wherein the sampling parameters and the one or more compressed sensing schemes are received via a graphical user interface.

15. The electronic device of any one of claims 9-14, wherein a selection of a model-based signal representation for metric analysis are received via a graphical user interface.

16. The electronic device of any one of claims 9-15, wherein the obtained data comprises one or more of: an image file, an audio file, an RF signal, a communication signal, a radar data file, a multimedia file or a compressed version of any data.

17. The electronic device of any one of claims 9-16, or the method of any one of claims 1-8, wherein the sampling parameters comprises one or more of: a sampling rate, down sampling frequency, up sampling frequency, maximum samples and error tolerance.

18. A non-transitory computer-readable medium storing program instructions that, when executed by one or more processors, cause the one or more processors to:
obtain data of a scene to be reconstructed;
receive sampling parameters and one or more compressed sensing schemes to be applied for sampling and reconstruction of the obtained data;
reconstruct the data the using one or more compressed sensing schemes, in accordance with received sampling parameters; and
compare the reconstructed data to an original data for each of the compressed sensing schemes.
